# EUROPEAN PATENT SPECIFICATION

(11) **EP 1 837 317 B1**
(45) Date of publication and mention of the grant of the patent: **20.08.2014**
(21) Application number: 07251158.7
(22) Date of filing: 20.03.2007
(51) Int. Cl.: C04B 35/581, H01L 21/683

(54) **Electrostatic chuck and manufacturing method thereof**
Elektrostatische Einspannvorrichtung und Herstellungsverfahren dafür
Mandrin électrostatique et son procédé de fabrication

(30) Priority: 24.03.2006 JP 2006081975
(43) Date of publication of application: 26.09.2007
(73) Proprietor: NGK Insulators, Ltd., Nagoya-City, Aichi Pref. 467-8530 (JP)
(72) Inventor: Mori, Yutaka, c/o NGK Insulators Ltd., Nagoya City, Aichi-ken, 467-8530 (JP); Nobori, Kazuhiro, c/o NGK Insulators Ltd., Nagoya City, Aichi-ken, 467-8530 (JP)
(74) Representative: Paget, Hugh Charles Edward

(56) References cited:
- EP-A2- 1 420 004
- JP-A- 2005 294 648
- US-A1- 2003 066 587

## Description

### BACKGROUND OF THE INVENTION

### 1. Field of the Invention

The present invention relates to an electrostatic chuck as a semiconductor manufacturing apparatus, and to a manufacturing method thereof.

### 2. Description of the Related Art

Heretofore, in a process of manufacturing a semiconductor, an electrostatic chuck has been widely used in order to hold a substrate such as a wafer. The electrostatic chuck fixes the substrate by using electrostatic force. In general, in the electrostatic chuck, a dielectric layer is formed on an electrode. As the electrostatic chuck for holding the substrate, there have been widely used a type using electrostatic force called Coulomb force generated between the substrate and the electrode, and a type using electrostatic force called Johnson-Rahbek force generated between a surface of the dielectric layer and the substrate. In order to enhance suction force and a detachment response for the substrate in the electrostatic chuck using the Johnson-Rahbek force, it has been necessary to reduce volume resistivity of a base material constructing the electrostatic chuck as described, for example, in Japanese Patent Laid-Open Publication No. 2003-55052.

### SUMMARY OF THE INVENTION

An aluminum nitride material described in the foregoing Japanese Patent Laid-Open Publication No. 2003-55052 contains samarium (Sm). It is necessary to set, at 6 E9 to 2 E10Ω•cm, the volume resistivity of the electrostatic chuck using the aluminum nitride material. This is because there are apprehensions that the detachment performance for the wafer will be decreased when the volume resistivity is larger than 2 E10Ω•cm, and that the suction force for the substrate will be decreased when the volume resistivity is smaller than 6 E9 Ω •cm.

The volume resistivity is usually controlled by a firing temperature for the aluminum nitride material. It has been necessary to sinter the aluminum nitride material described in the foregoing Japanese Patent Laid-Open Publication No. 2003-55052 in a small temperature range of 1785 to 1815°C. There have been apprehensions that the volume resistivity may not be lowered when the firing temperature drops down below 1785°C as the lower limit value, and that an appearance defect may occur on the aluminum nitride material owing to seepage of Sm phases in a body thereof.

As described above, when such a base body of the electrostatic chuck is produced by using source material powder in which the samarium (Sm) is added to aluminum nitride (AlN), the base body has property that samarium-aluminum oxide phases are prone to be precipitated on grain boundaries of particles of the aluminum nitride. Since the samarium-aluminum oxide phases easily conduct a current therethrough, it is considered that the volume resistivity is decreased by the fact that the samarium-aluminum oxide phases are evenly dispersed in the entirety of the dielectric layer.

The electrode is usually embedded in the base body of the electrostatic chuck, and for example, molybdenum is employed as a material of the embedded electrode.

In the case of using the molybdenum, a minute stress distortion occurs in the vicinity of the electrode. The samarium-aluminum oxide phases are more prone to segregate in the vicinity of the electrode owing to the stress distortion. Accordingly, there has been a problem that it becomes difficult for the samarium-aluminum oxide phases to be evenly dispersed in the entirety of the dielectric layer.

The following problems have been present. Specifically, an oxygen amount in the source material powder varies to thereby change a composition of the samarium-aluminum oxide phases. In such a way, the segregation occurs, and the volume resistivity of the electrostatic chuck is varied, resulting in destabilization of suction characteristics and detachment characteristics for the substrate.

In this connection, it is an object of the present invention to provide an electrostatic chuck in which the samarium-aluminum oxide phases are evenly dispersed in the entirety of the base body when the embedded electrode is provided in the base body, and to provide a manufacturing method of the electrostatic chuck.

The electrostatic chuck according to the present invention is set out in claim 3.

A method of manufacturing an electrostatic chuck according to the invention is set out in claim 1.

In accordance with the electrostatic chuck and the manufacturing method thereof according to the present invention, a segregation amount of the samarium-aluminum oxide phases in the vicinity of the electrode can be reduced. In particular, resistivity of the dielectric layer can be stably controlled in such a manner that the samarium-aluminum oxide phases are evenly dispersed in the dielectric layer. In such a way, the electrostatic chuck can be provided, in which the suction performance and the detachment response for the substrate are made highly compatible with each other.

### BRIEF DESCRIPTION OF THE DRAWINGS

FIG. 1 is a cross-sectional view of an electrostatic chuck according to an embodiment of the present invention.
FIG. 2 is a perspective view showing a mesh-like electrode embedded in a base body of FIG. 1.
FIG. 3 is a perspective view showing an electrode made of punching metal.
FIG. 4 is an SEM photograph of a cross section in a part of the base body manufactured by using a method according to the embodiment of the present invention, in which magnification is 200 times.
FIG. 5 is an SEM photograph of a cross section in the vicinity of the mesh-like electrode in the base body manufactured by using the method according to the embodiment of the present invention, in which the magnification is 400 times.
FIG. 6 is an SEM photograph of a cross section in a part of a base body manufactured by using a method according to a comparative example, in which the magnification is 200 times.
FIG. 7 is an SEM photograph of a cross section in the vicinity of a mesh-like electrode in a base body manufactured by using a method according to a comparative example, in which the magnification is 400 times.
FIG. 8 is a schematic view showing an image obtained by binarizing the SEM photograph of FIG. 5, in which black portions represent samarium-aluminum oxide phases, and a white portion represents the other portion.
FIG. 9 is a schematic view showing an image obtained by binarizing the SEM photograph of FIG. 7, in which black portions represent the samarium-aluminum oxide phases, and a white portion represents the other portion.

### DETAILED DESCRIPTION OF THE EMBODIMENTS

A description will be made below of an embodiment of the present invention.

### [Construction of Electrostatic Chuck]

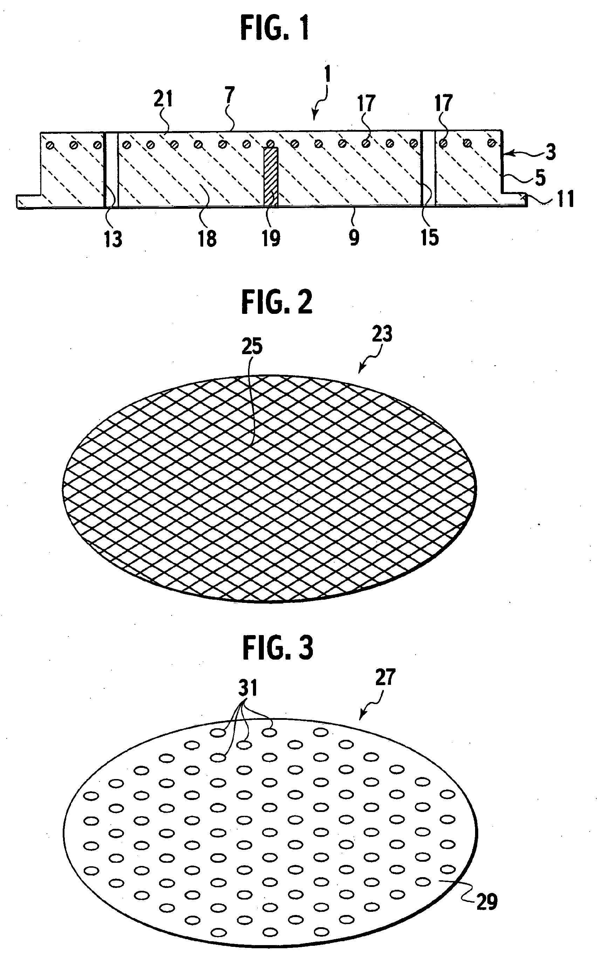

FIG. 1 is a cross-sectional view showing an electrostatic chuck according to an embodiment of the present invention. In the electrostatic chuck, an outer shape thereof is formed into a disc shape, and FIG. 1 shows a cross section passing through a diametrical center of the outer shape.

The electrostatic chuck 1 is composed of a base body 3 made of ceramics, an electrode 17 embedded in an upper side of an inside of the base body 3, and an electrode terminal 19 connected to the electrode 17.

### [Base Body]

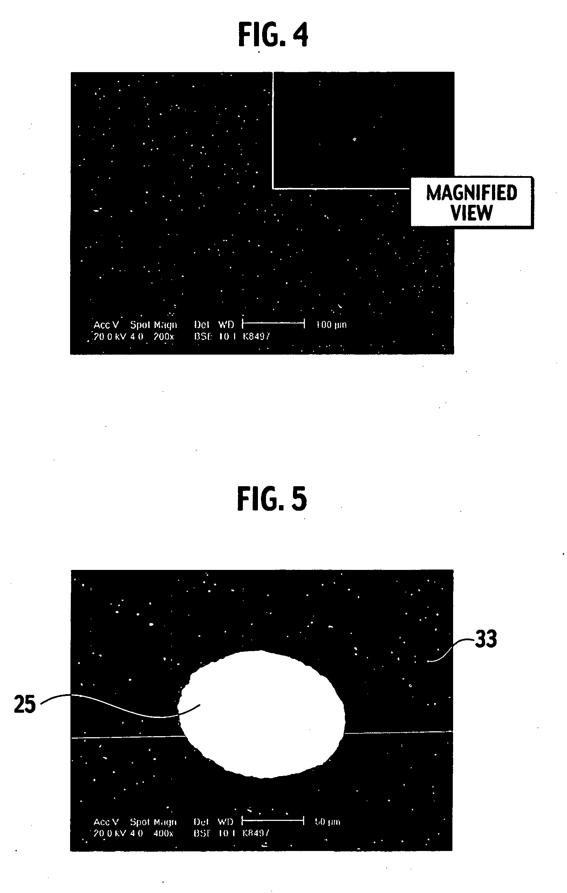

The base body 3 is formed of an aluminum nitride sintered body containing samarium. Then, as will be described later, samarium-aluminum oxide phases 33 (refer to FIG. 5 and the like) are precipitated on grain boundaries of crystal particles of the aluminum nitride constructing the base body 3. The samarium-aluminum oxide phases 33 are, for example, SmAl₁₁O₁₈ phases, and have property to easily conduct a current therethrough. Accordingly, the samarium-aluminum oxide phases 33 are continuously formed along the grain boundaries of the crystal particles, thus making it possible to reduce volume resistivity of the base body 3. When the samarium-aluminum oxide phases 33 are the SmAl₁₁O₁₈ phases, an effect of reducing the volume resistivity is particularly high.

In the base body 3, an outer shape thereof is formed into a substantial disc shape. Both of an upper surface of the base body 3, which becomes a base body surface 7, and a lower surface thereof, which becomes a base body back surface 9, are formed into a planar shape, and are arranged parallel to each other. The base body surface 7 is constructed as a substrate mounting surface for sucking and mounting a substrate as a processing object. An outer circumferential side surface 5 of the base body 3 is provided on an outer circumference of the base body 3. Then, on a lower end of the outer circumferential side surface 5, a flange 11 rectangular in cross section may be provided along a circumferential direction so as to protrude to a diametrical outside. Lift pin holes 13 and 15 are formed near the outer circumference of the base body 3 so as to vertically penetrate the base body 3.

### [Electrode]

In the upper side of the inside of the base body, the electrode 17 containing molybdenum (Mo) is embedded. Ones with various shapes, such as a wire netting (mesh) and punching metal, can be used as long as these can be embedded in the base body.

FIG. 2 is a perspective view showing a mesh-like electrode 23. The mesh-like electrode 23 is formed by combining a plurality of linear bodies 25 arranged in a grid shape. As shown in FIG. 3, an electrode formed of punching metal 27 can also be used.

### [Dielectric layer]

A portion between the electrode and the base body surface 7 is a dielectric layer 21, and in the dielectric layer 21, the samarium-aluminum oxide phases 33 are precipitated on the grain boundaries of the crystal particles of the aluminum nitride. Since there is a difference in thermal expansion coefficient between the electrode 17 and the base body, a minute stress distortion occurs between the electrode 17 and the base body in the periphery of the electrode as the electrostatic chuck 1 is heated up at the time of manufacture thereof. It is considered that the samarium-aluminum oxide phases 33 are more prone to be precipitated in the vicinity of the electrode where the stress distortion has occurred.

As described above, when the electrode 17 is embedded in the inside of the base body, the samarium-aluminum oxide phases 33 are prone to be concentratedly precipitated in the vicinity of the electrode 17, that is, prone to segregate. Therefore, the samarium-aluminum oxide phases 33 are inhibited from being evenly dispersed in the entirety of the dielectric layer. It is necessary to prevent the samarium-aluminum oxide phases 33 from segregating in the vicinity of the electrode 17 as much as possible.

Under such a technical concept, in the electrostatic chuck 1 according to the present invention, a precipitation amount of the samarium-aluminum oxide phases 33 in the vicinity of the electrode 17 is reduced, and in such a way, the samarium-aluminum oxide phases 33 are evenly dispersed in the entirety of the dielectric layer.

### [Samarium-Aluminum Oxide Phase]

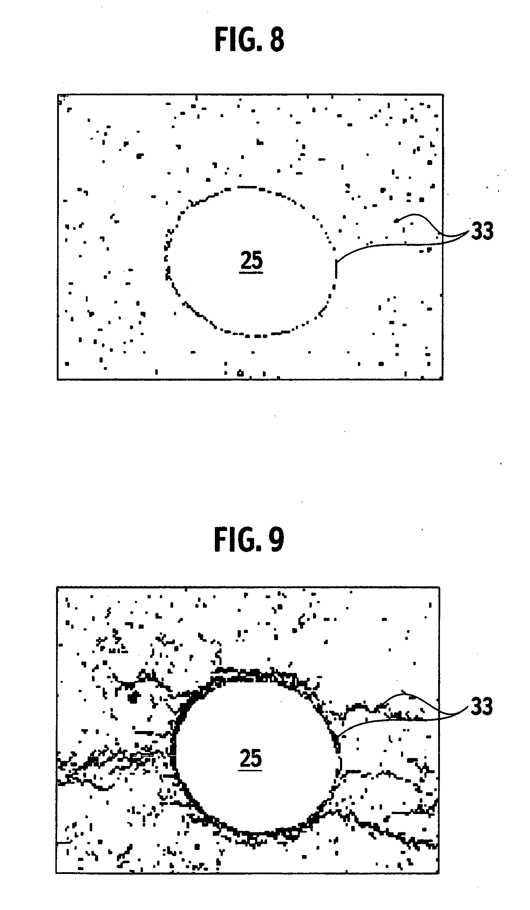

A content of the samarium-aluminum oxide phases 33 is set at 2.5% or less in terms of an area ratio. A description will be made of a way of obtaining the area ratio by using FIG. 8. FIG. 8 is a schematic view showing a degree of precipitation of the samarium-aluminum oxide phases 33 in the vicinity of the electrode, in which black portions represent the samarium-aluminum oxide phases 33, and a white portion represents the other portion.

As described above, a range of which sides have predetermined lengths is set around the electrode 17, and an area ratio of the samarium-aluminum oxide phases 33 is obtained. Specifically, as shown in FIG. 8, an area ratio of the black portion present within a rectangular area, for example, around the linear body 25 of the mesh-like electrode 23, is calculated. In this case, a lateral length of the rectangular area is 310 *µ*m, and a longitudinal length thereof is 230 µm. When the area ratio is 2.5% or less, the segregation of the samarium-aluminum oxide phases 33 in the vicinity of the linear body 25 of the mesh-like electrode 23 is reduced, leading to an effect that the samarium-aluminum oxide phases 33 can be evenly dispersed in the entirety of the base body 3.

### [Manufacturing Method of Electrostatic Chuck]

A description will be briefly made below of a manufacturing method of the electrostatic chuck 1 according to the embodiment of the present invention.

This manufacturing method includes: a preliminary molded body fabrication step of forming a preliminary molded body made of the ceramics containing samarium oxide and the aluminum nitride; a molded body fabrication step of disposing the electrode 17 containing the molybdenum on a predetermined outer surface of the preliminary molded body, then disposing the source material powder containing the samarium oxide and the aluminum nitride on the predetermined outer surface and the electrode 17, and pressure-molding the preliminary molded body, the electrode 17, and the source material powder, thereby forming a molded body in which the electrode 17 is embedded; and a firing step of heating and sintering the molded body, and then cooling the sintered body to room temperature.

A cooling rate at the cooling step is 200°C/hour or more. The cooling rate is preferably 200 to 900°C/hour, more preferably, 300 to 900°C/hour. When the cooling rate is accelerated to more than 900°C/hour, there is a possibility that the aluminum nitride sintered body may be broken owing to the rapid cooling, and so on. Accordingly, it is preferable to set the cooling rate at 900°C/hour or less. When the cooling rate is set at less than 200°C, the samarium-aluminum oxide phases 33 coagulate and segregate in the vicinity of the electrode. Accordingly, it is preferable to set the cooling rate at 200°C/hour or more.

According to this manufacturing method, the coagulation and segregation of the samarium-aluminum oxide phases 33 on the grain boundaries becomes extremely small. Accordingly, the samarium-aluminum oxide layer 33 is evenly dispersed in the entirety of the dielectric layer, and the coagulation and segregation of the samarium-aluminum oxide layer 33 are reduced also in the vicinity of the electrode. The samarium-aluminum oxide phases 33 are evenly dispersed, and in such a way, the samarium-aluminum oxide phases 33 precipitated on the aluminum nitride crystal grain boundaries connect to one another to form a conduction path. Thus, resistivity of the entirety of the dielectric layer is reduced, and the volume resistivity is stabilized.

### EXAMPLES

A description will be made of the present invention more specifically through examples.

As shown in Table 1 to be shown below, the base bodies 3 were cooled while setting the cooling rate in the cooling step at 100°C/hour, 200°C/hour, 300°C/hour, and 400°C/hour (in a furnace). Then, six pieces of the electrostatic chucks were fabricated under each cooling condition. From each of the fabricated electrostatic chucks, a sample was cut out, and a cross-sectional portion thereof containing the electrode was polished, and observed by means of a scanning electron microscope. Then, the area ratio of the precipitated samarium-aluminum oxide phases 33 on the base body portion in the vicinity of the electrode is calculated by binarization, and meanwhile, the volume resistivity was measured. The volume resistivity was measured according to the method of JIS C 2141. Note that, here, the volume resistivities are described by using an abbreviation method. For example, 1.5×10¹⁰ is represented as 1.5 E10. Variations of the volume resistivities of the electrostatic chucks fabricated are described by a difference between logarithms of the maximum value and the minimum value under each same manufacturing condition. As the difference is smaller, the electrostatic chucks among which the volume resistivities are less various are obtained.

**[Table 1]**

| Temperature drop rate | 100°C/hr | 200°C/hr | 300°C/hr | 400°C/hr |
|---|---|---|---|---|
| Area ratio of samarium-aluminum oxide phase | 8.1% | 2.4% | 2.2% | 1.9% |
| Average value of volume resistivities (Ω•cm) | 2.5 E10 | 9.9 E9 | 9.2 E9 | 9.0 E9 |
| Standard deviation of logarithms of volume resistivities log(Ω•cm) | 0.75 | 0.56 | 0.50 | 0.43 |

As obvious from Table 1, when the cooling rate was 200°C/hour or more, the area ratio of the precipitated samarium-aluminum oxide phases 33 became 2.5% or less, which was smaller than that in the case where the cooling rate was 100°C. In such a way, the volume resistivities were decreased to a suitable range for the electrostatic chucks, and the variations thereof were reduced. It was found out that, by further setting the cooling rate at 300°C/hour or more, the variations of the volume resistivities became further smaller, and it became possible to control the volume resistivities to a more suitable range.

FIGS. 4 to 7 are SEM photographs obtained in the examples in Table 1, where the cooling rate was 400°C/hour. FIGS. 4 and 5 are SEM photographs according to the present invention, showing the case where the cooling rate was 400°C/hour. Magnification in FIG. 4 is 200 times, and magnification in FIG. 5 is 400 times. FIG. 8 is a schematic view obtained by binarizing the photograph of FIG. 5, in which black portions represent the samarium-aluminum oxide phases, and a white portion represents the other portion.

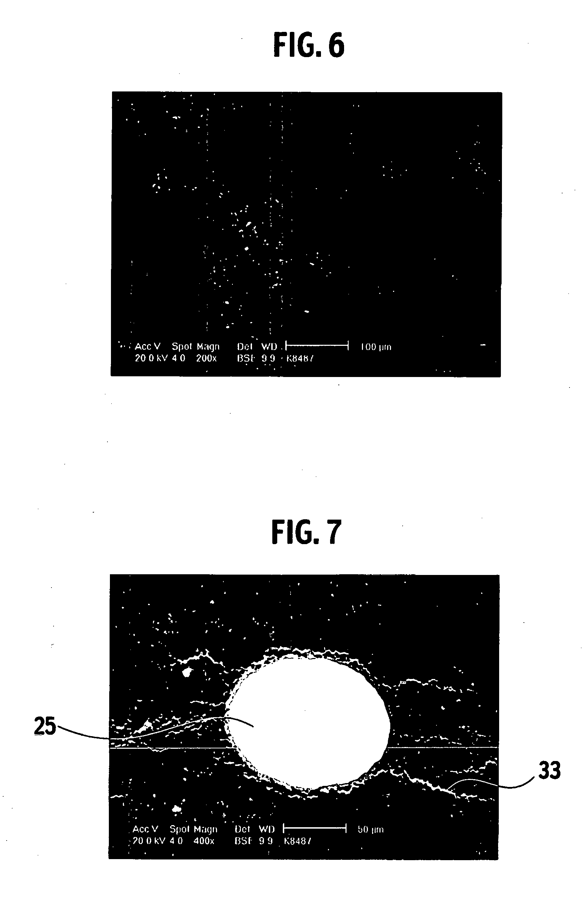

FIGS. 6 and 7 are SEM photographs according to the comparative example in Table 1, showing the case where the cooling rate was 100°C/hour. Magnification in FIG. 6 is 200 times, and magnification in FIG. 7 is 400 times. FIG. 9 is a schematic view obtained by binarizing the photograph of FIG. 7, in which black portions represent the samarium-aluminum oxide phases, and a white portion represents the other portion.

As obvious from the above, in FIGS. 5 and 8, the samarium-aluminum oxide phases 33 are evenly dispersed and precipitated, and in particular, in the vicinity of the linear body 25 constructing the mesh-like electrode 23, the samarium-aluminum oxide phases 33 do not coagulate. However, in FIGS. 7 and 9, the samarium-aluminum oxide phases 33 are precipitated while segregating and coagulating, and in particular, in the vicinity of the linear body 25, the samarium-aluminum oxide phases 33 are precipitated much while coagulating.

While the samarium-aluminum oxide phases 33 are evenly dispersed in the entirety of the base body in FIG. 4, the samarium-aluminum oxide phases 33 coagulate and segregate in a part of the base body 3 in FIG. 6. Specifically, according to the present invention, the samarium-aluminum oxide phases 33 are evenly dispersed, and are evenly present to be thin on the grain boundaries of the aluminum nitride. Therefore, the black portions of the samarium-aluminum oxide phases 33 on the grain boundaries hardly appear when the SEM photograph is binarized. In the comparative example, the samarium-aluminum oxide phases 33 coagulate and segregate around the electrode, and are present much on a part of the grain boundaries in a biased manner. Accordingly, the black portions appear much when the SEM photograph is binarized.

As understood from a comparison between Table 1 and FIGS. 4 to 9, according to the present invention, the samarium-aluminum oxide phases 33 are evenly dispersed, and are present to be thin on the grain boundaries of the crystal particles of the aluminum nitride. Therefore, with small variations, the volume resistivities can be controlled within a suitable range for operations of the electrostatic chucks.

As shown in Table 2 to be shown below, electrostatic chucks were fabricated under conditions shown in Present invention examples 1 to 5 and Comparative examples 1 to 3, and volume resistivities of the electrostatic chucks were individually measured. Six pieces of the electrostatic chucks were fabricated under each same condition.

**[Table 2-1]**

| | Temperature drop rate | Oxygen amount of source material (wt%) | Additive amount of samarium (wt%) | Additive amount of alumina (wt%) | Additive amount of titanium (wt%) |
|---|---|---|---|---|---|
| Present invention example 1 | 400°C/hr | 0.7 | 3 | 1.02 | 0.5 |
| Present invention example 2 | 400°C/hr | 0.84 | 3 | 1.36 | 0.5 |
| Present invention example 3 | 400°C/hr | 0.87 | 3 | 1.30 | 0.5 |
| Present invention example 4 | 400°C/hr | 0.89 | 3 | 1.26 | 0.5 |
| Present invention example 5 | 400°C/hr | 1.0 | 3 | 1.66 | 0.5 |
| Comparative example 1 | 100°C/hr | 0.84 | 3 | 1.08 | 0.5 |
| Comparative example 2 | 100°C/hr | 0.87 | 3 | 1.08 | 0.5 |
| Comparative example 3 | 100°C/hr | 0.89 | 3 | 1.08 | 0.5 |

**[Table 2-2]**

| | Volume resistivity (Ω·cm) | Average value of volume resistivity (Ω·cm) | Difference (*) |
|---|---|---|---|
| Present invention example 1 | 6.5 E9 to 1.5 E10 | 0.98 E10 | 0.36 |
| Present invention example 2 | 7 E9 to 1.5 E10 | 1.0 E10 | 0.33 |
| Present invention example 3 | 7 E9 to 1.5 E10 | 1.0 E10 | 0.33 |
| Present invention example 4 | 8 E9 to 1.3 E10 | 1.0 E10 | 0.21 |
| Present invention example 5 | 8 E9 to 1.3 E10 | 1.0 E10 | 0.21 |
| Comparative example 1 | 1 E10 to 5 E10 | 2.2 E10 | 0.70 |
| Comparative example 2 | 8 E9 to 4 E10 | 1.8 E10 | 0.70 |
| Comparative example 3 | 5 E9 to 3 E10 | 1.2 E10 | 0.78 |

| | | | |
|---|---|---|---|
| *: Difference between maximum value and minimum value of logarithm of volume resistivity (Ω·cm) | | | |

In Present invention examples 1 to 5, the electrostatic chucks were cooled in the furnace at the cooling rate of 400°C/hour, and in Comparative examples 1 to 3, the electrostatic chucks were cooled at the cooling rate of 100°C/hour. From results of Table 2, it is understood that the variations of the volume resistivities of Present invention examples 1 to 5 are smaller than those of Comparative examples 1 to 3, and that good volume resistivities are exhibited in the Present inventions.

A description will be made below of a molar ratio of the samaria (samarium oxide; Sm₂O₃) to the alumina (Al₂O₃).

In Comparative examples 1 to 3 in Table 2, the molar ratio of the samaria to the alumina was set at 0.3. Meanwhile, the molar ratio of the samaria to the alumina in Present invention examples 1 to 5 was set at 0.28. In Present invention examples 1 to 5, the variations of the volume resistivities are smaller than those in Comparative examples 1 to 3. More suitable volume resistivities in the foregoing Present invention examples are exhibited.

As described above, the samarium-aluminum oxide phases are precipitated on the grain boundaries of the crystal particles of the aluminum nitride. SmAl₁₁O₁₈ phases as a type of the samarium-aluminum oxide phases are continuously formed, and the volume resistivity is thereby decreased. When the oxygen amount of the source material is equal, the additive amount of the alumina is increased to reduce the molar ratio of the samaria to the alumina, thus making it possible to increase a precipitation amount of the SmAl₁₁O₁₈.

In order to set the molar ratio of the samaria to the alumina at 0.28, the additive amount of the alumina is 1.36 wt% when the oxygen amount of the source material is 0.84 wt%, the additive amount of the alumina is 1.30 wt% when the oxygen amount of the source material is 0.87 wt%, and the additive amount of the alumina is 1.26 wt% when the oxygen amount of the source material is 0.80 wt%.

In Present invention example 3, the molar ratio of the samaria to the alumina is 0.28. By reducing the molar ratio of the samaria and the alumina from 0.3 to 0.28, SmAlO₃ and Al₅O₆N phases are decreased, and the SmAl₁₁O₁₈ phases are increased.

From the above, it was understood that it became possible to increase the SmAl₁₁O₁₈ phases in such a manner that the additive amount of the alumina was controlled in accordance with the oxygen amount of the source material so that the molar ratio of the samaria to the alumina could be 0.28. In such a way, it became possible to stabilize the volume resistivity of the fabricated electrostatic chuck, and to enhance the suction characteristics and detachment characteristics of the electrostatic chuck.

## Claims

1. A method of manufacturing an electrostatic chuck, comprising:
forming a preliminary (17) molded body made of ceramics containing samarium oxide and aluminum nitride;
disposing an electrode containing molybdenum on a predetermined outer surface of the preliminary molded body, then disposing source material powder of the aluminum nitride containing the samarium oxide on the predetermined outer surface and the electrode, and pressure-molding the preliminary molded body, the electrode, and the source material powder, thereby forming a molded body in which the electrode is embedded; and
heating and sintering said molded body in which the electrode is embedded, and then cooling the molded body to room temperature,
wherein the cooling rate in the cooling step is 200 °C/hour or more,;
wherein the molar ratio of samarium oxide to aluminum oxide is set at 0.28 by adding, to source material of the aluminum nitride powder, aluminum oxide of an amount corresponding to an oxygen amount of the source material powder, so as to constantly set an oxygen amount in the sintered body and SmAl₁₁O₁₈ phases are precipitated in the sintered body.

2. The method of manufacturing an electrostatic chuck according to claim 1, wherein said cooling rate is set at 300 to 900°C/hour.

3. An electrostatic chuck obtainable by the method according to claim 1 or claim 2.

## Patentansprüche

1. Verfahren zur Herstellung einer elektrostatischen Halterung, umfassend:
das Bilden eines vorläufigen (17) Formkörpers aus Keramik, der Samariumoxid und Aluminiumnitrid enthält;
das Anordnen einer Molybdän-enthaltenden Elektrode auf einer vorbestimmten Oberfläche an der Außenseite des vorläufigen Formkörpers, danach das Anordnen von Pulver des Aluminiumnitrid-Ausgangsmaterials, das das Samariumoxid enthält, auf der vorbestimmten Oberfläche an der Außenseite und der Elektrode und das Spritzgießen des vorläufigen Formkörpers, der Elektrode und des Pulvers des Ausgangsmaterials, wodurch ein Formkörper gebildet wird, in den die Elektrode eingebettet ist; und
das Erhitzen und Sintern des Formkörpers, in den die Elektrode eingebettet ist, und anschließend ein Abkühlen des Formkörpers auf Raumtemperatur,
worin die Abkühlgeschwindigkeit während des Abkühlschritts 200 °C/h oder mehr beträgt;
worin das Molverhältnis zwischen Samariumoxid und Aluminiumoxid durch Zusetzen von Aluminiumoxid zu dem Ausgangsmaterial des Aluminiumnitridpulvers in einer Menge, die der Menge an Sauerstoff des Pulvers des Ausgangsmaterials entspricht, auf 0,28 festgelegt ist, so dass eine Sauerstoffmenge in dem Sinterkörper konstant festgelegt ist und SmAl₁₂O₁₈-Phasen in dem Sinterkörper ausgefällt werden.

2. Verfahren zur Herstellung einer elektrostatischen Halterung nach Anspruch 1, worin die Abkühlgeschwindigkeit auf 300 bis 900 °C/h festgelegt ist.

3. Elektrostatische Halterung, die durch das Verfahren nach Anspruch 1 oder Anspruch 2 erhalten werden kann.

## Revendications

1. Procédé de fabrication d'un mandrin électrostatique, comprenant :
la formation d'un corps moulé préliminaire (17) constitué de céramiques contenant de l'oxyde de samarium et du nitrure d'aluminium ;
la disposition d'une électrode contenant du molybdène sur une surface externe prédéterminée du corps moulé préliminaire, puis la disposition de poudre de matériau source du nitrure d'aluminium contenant l'oxyde de samarium sur la surface externe prédéterminée et l'électrode, et le moulage sous pression du corps moulé préliminaire, l'électrode, et la poudre de matériau source, de manière à former un corps moulé dans lequel l'électrode est incorporée ; et
le chauffage et le frittage dudit corps moulé dans lequel l'électrode est incorporée et ensuite le refroidissement du corps moulé à température ambiante,
dans lequel la vitesse de refroidissement dans l'étape de refroidissement est de 200 °C/heure ou plus ;
dans lequel le rapport molaire de l'oxyde de samarium à l'oxyde d'aluminium est défini à 0,28 par ajout, au matériau source de la poudre de nitrure d'aluminium, d'oxyde d'aluminium d'une quantité correspondant à une quantité d'oxygène de la poudre de matériau source, de manière à définir constamment une quantité d'oxygène dans le corps fritté et les phases SmAl₁₁O₁₈ sont précipitées dans le corps fritté.

2. Procédé de fabrication d'un mandrin électrostatique selon la revendication 1, dans lequel ladite vitesse de refroidissement est définie à 300 à 900 °C/heure.

3. Mandrin électrostatique pouvant être obtenu par le procédé selon la revendication 1 ou la revendication 2.
